# DEMANDE DE BREVET EUROPEEN

(11) **EP 1 115 141 A1**
(43) Date de publication de la demande: **11.07.2001**
(21) Numéro de dépôt: 00200022.2
(22) Date de dépôt: 06.01.2000
(51) Int. Cl.: H01J 37/32, H05H 1/24

(54) **Procédé et dispositif de traitement de surface d'un corps filiforme**

(71) Demandeur: TePla AG, 85551 Kirchheim bei München (DE)
(72) Inventeur: Begounov, Stanislav, 1400 Yverdon-les-Bains (CH); Goloviatinskii, Sergei, 1400 Yverdon-les-Bains (CH); Konavko, Arkady, 1400 Yverdon-les-Bains (CH); Konavko, Rudolph, 1400 Yverdon-les-Bains (CH)
(74) Mandataire: Ganguillet, Cyril

(57) **Abrégé**

Traitement et dispositif de traitement de surface d'un corps filiforme avec un plasma généré par une décharge électrique entre deux électrodes agencées le long d'un tube ouvert aux deux extrémités, dans lequel le corps filiforme défile dans le tube en étant plongé dans le plasma.

## Description

La présente invention concerne un procédé et un dispositif de traitement de surface d'un corps filiforme avec un plasma généré par une décharge électrique. L'invention concerne également des applications de ce procédé.

Au sens de la présente invention, on entend par corps filiforme un objet présentant une dimension longitudinale beaucoup plus grande que ses dimensions transversales. Il s'agit notamment de toutes sortes de fils, c'est à dire monofils, fils constitués de fibres tressées, fils constitués de fibres ou filaments mêlés ou entrelacés, en matériau naturel ou synthétique, à usages textiles ou techniques. Il s'agit également de fibres à usage techniques, par exemple des fibres optiques, ainsi que des ficelles, câbles ou cordons. Il s'agit également de bandes et rubans plats. Peuvent également entrer dans le champ d'application de l'invention le traitement de tiges ou de barres.

Le brevet US-4,397,893 décrit un procédé de traitement de surface d'une tige, dans lequel une torche de plasma orientée perpendiculairement à et en direction de la tige est déplacée le long de celle-ci, pendant que la tige est mise en rotation autour de son axe. Ce dispositif nécessite le déplacement synchronisé d'un dispositif de préchauffage, de la torche à plasma et du support de la tige. La faible vitesse d'exécution du procédé dans la direction longitudinale de la tige liée à la nécessité de faire tourner celle-ci autour de son axe, rend ce procédé incompatible avec la plupart des lignes de production industrielle de fils et produits similaires.

Le brevet US-3,486,306 décrit un générateur de plasma permettant d'obtenir un jet de plasma ayant la forme d'un rideau. Les paramètres de ce plasma sont sensiblement uniformes le long du rideau, dans une direction perpendiculaire à la direction du flux de plasma. Il permet le traitement d'une surface d'une bande. Cependant, lors du passage sous le rideau de plasma, seul un côté de la bande est traité. Il a été constaté que la génération de ce type de plasma s'accompagnait d'une émission importante de rayons UV, allant jusqu'à entraîner des effets indésirables de photoionisation du matériau de la surface à traiter. Par ailleurs, l'atmosphère à proximité du rideau ne peut être contrôlée avec une précision suffisante pour effectuer un traitement plasmochimique homogène. Enfin, le faible rendement énergétique obtenu en mettant en oeuvre cette technologie de jet de plasma en rideau en constitue un inconvénient économique.

Un premier but de la présente invention est de proposer un traitement de surface produisant un résultat homogène, en une seule opération, sur toute la surface, c'est à dire de tous les côtés, d'une portion longitudinale d'un corps filiforme.

Un deuxième but de la présente invention est de proposer un traitement de ce type qui permette de varier le temps de traitement dans un domaine très large.

Un troisième but de la présente invention est de proposer un traitement de ce type effectué dans une atmosphère parfaitement contrôlée, permettant d'utiliser divers types de plasma et d'effectuer différents traitements plasmo-chimiques dans un même dispositif.

Un quatrième but de la présente invention est de proposer un traitement du type précité qui puisse s'intégrer dans une ligne de production en modifiant le moins possible les conditions et paramètres de cette production, en amont et en aval.

Ces buts sont atteints grâce à un procédé du type défini d'entrée présentant les caractéristiques de la revendication 1 et grâce à un dispositif présentant les caractéristiques de la revendication 14.

Le dispositif selon l'invention comprend un tube en matériau diélectrique, présentant deux extrémités ouvertes, dont la section transversale intérieure est choisie de façon à pouvoir recevoir une portion d'un corps filiforme, ou d'une pluralité de corps filiformes agencés parallèlement entre eux, en laissant un espace entre la surface du ou des corps à traiter et la paroi intérieure du tube suffisant pour générer un plasma enveloppant le ou les dit(s) corps filiforme(s). Le dispositif comprend également au moins deux électrodes agencées le long ou auprès du tube, en étant espacées entre elles en direction longitudinale du tube.

Le procédé selon l'invention est mis en oeuvre en appliquant une tension électrique apte à produire une décharge électrique dans le tube, entre les électrodes, de façon à générer une colonne de plasma confinée sensiblement entre les parois intérieures du tube, et en soumettant la portion du (ou des) corps filiforme(s) disposé(s) dans le tube, à un mouvement relatif par rapport au tube, dans la direction longitudinale de celui-ci.

Un espace d'au moins 50 µm entre la surface du corps filiforme et la paroi intérieure du tube, permet déjà à une colonne de plasma de s'établir entre eux. Une distance entre surface extérieure du corps filiforme et paroi intérieure du tube supérieure à 1 mm est cependant préférable pour obtenir une colonne de plasma plus homogène, plonger la partie de corps filiforme passant entre les deux électrodes entièrement dans le plasma, et éviter des contacts indésirables entre corps filiforme et tube.

L'aire de la section transversale intérieure du tube est d'au moins 0,03 mm², et elle est comprise de préférence entre. 3 mm2 et 20 mm2. Une aire supérieure, jusqu'à 3 cm² ou d'avantage, est possible, mais s'accompagne d'une dépense d'énergie accrue, la dépense d'énergie étant fonction du volume de la colonne de plasma. La section transversale intérieure du tube peut être de forme quelconque mais, de préférence, cette section est de forme circulaire sur toute la longueur du tube pour le traitement d'un corps filiforme lui-même de section approximativement circulaire ou similaire. Pour le traitement d'un ruban plat ou d'une pluralité de fils disposés parallèlement et à proximité les uns des autres, la section transversale intérieure du tube est de préférence oblongue. Elle peut présenter la forme d'une ellipse allongée ou d'une fente rectangulaire, éventuellement arrondie aux deux extrémités, de sorte que la distance de la paroi intérieure du tube à la surface du (des) corps filiforme(s) reste approximativement constante.

Selon un premier aspect de la présente invention, la portion de surface à traiter passant dans le tube est complètement plongée dans le plasma pendant le déplacement du corps filiforme, et se trouve donc à proximité immédiate ou en contact avec les molécules, radicaux métastables, atomes excités et/ou ions composant ce plasma.

La durée du traitement d'une unité de longueur du corps filiforme dépend essentiellement de la vitesse de défilement du corps filiforme à l'intérieur du tube et de la longueur de ce tube. La longueur du tube peut être comprise entre 5 mm et 1 m, et de préférence entre 5 cm et 20 cm de long.

La vitesse de défilement peut varier de quelques centimètres/seconde à plusieurs dizaines de mètres/seconde. De préférence, on adopte la même vitesse de défilement que les postes de travail amont et/ou aval de l'usine de production du corps filiforme et on adapte la longueur du tube, ou d'une pluralité de tubes placés en série, aux caractéristiques du traitement désiré.

Selon un autre aspect de la présente invention, le tube est ouvert à ses deux extrémités, extrémités que traverse le corps filiforme en défilement. Le tube n'est pas nécessairement mis sous vide partiel, au moyen d'une pompe ou en étant placé dans une enceinte à vide, qui est en soi coûteuse et dont le fonctionnement entraînerait un surcoût du traitement, car le plasma peut être généré entre les électrodes à une pression égale ou proche de la pression ambiante, l'intérieur du tube étant en communication fluide avec l'atmosphère extérieure. De plus, dans le cas d'un traitement plasmochimique, la concentration de molécules actives est plus importante dans un plasma généré sous pression ambiante que dans un plasma généré sous vide partiel, ce qui rend le traitement plasmochimique plus efficace et permet d'en réduire la durée.

Selon un mode d'exécution préféré du dispositif selon l'invention, destiné à être agencé dans une ligne de production de fils sans interrompre celle-ci, le tube est formé d'au moins deux parties, susceptibles d'être séparées pour présenter vis-à-vis d'une portion de fil située entre deux postes de travail préexistants, une gouttière ouverte, dans le sens longitudinal, et un couvercle, les deux parties du tube pouvant être assemblées entre elles de manière étanche le long de leurs surfaces de jonction, après que le fil ait été positionné dans la gouttière.

Le matériau du tube est choisi parmi les matériaux diélectriques résistant à la température créée par la proximité du plasma, l'extérieur du tube pouvant être refroidi. Le tube peut notamment être constitué de quartz ou de céramiques, en particulier les céramiques à base d'alumine, présentant une bonne conductibilité thermique tout en étant diélectriques, usinables pour des tubes de grande longueur.

Les électrodes peuvent présenter toute forme permettant de produire une décharge électrique et de générer un plasma dans le tube. De préférence, pour améliorer l'homogénéité du plasma dans le tube, elles se présentent sous forme de disque ou de cylindre percé, de géométrie adaptée au tube. L'orifice central d'une électrode peut affleurer la paroi intérieure du tube. Pour éviter la contamination du plasma par les matériaux provenant de l'érosion des électrodes, une ou plusieurs de celles-ci peuvent être disposées à l'extérieur du tube, notamment sous forme de cylindres creux ou d'anneaux, en étant isolées ainsi de l'intérieur par le matériau diélectrique du tube.

Le plasma à l'intérieur du tube peut être entretenu par un flux de gaz porteur, tel que de l'argon, de l'air ou de l'hélium. Le flux gazeux peut véhiculer une composante de traitement plasmochimique, telle que oxygène, tétrafluorure de carbone, tétrachlorure de silicium. Le flux gazeux se déplace dans le tube essentiellement en direction longitudinale, contribuant à la stabilisation du plasma dans le tube. De préférence, l'introduction du flux de gaz d'apport par des moyens d'injection, tels que tubulures d'introduction ou buses, s'effectue dans une zone du tube située entre les deux électrodes les plus espacées, de sorte que le gaz s'écoule en deux flux depuis la zone d'introduction en direction des électrodes, c'est à dire vers les extrémités et l'extérieur du tube. Les flux dirigés vers l'extérieur permettent de mieux contrôler l'atmosphère dans le tube, de nettoyer le fil de ses éventuels contaminants (poussières ou humidité déposées sur le fil) à l'entrée du tube, et d'évacuer les matériaux d'électrodes vaporisés vers l'extérieur.

Par un agencement approprié de tubulures ou buses d'injection, une composante transversale de rotation peut être impartie à l'écoulement du flux gazeux, qui devient un mouvement de tourbillon à l'intérieur du tube.

Selon un mode de réalisation préféré de l'invention, une pluralité de flux de gaz porteurs, en particulier de gaz présentant des compositions différentes, sont introduits dans des zones distinctes du tube, échelonnées entre les deux électrodes les plus espacées. Dans ce mode de réalisation, un ou plusieurs flux gazeux peuvent être extraits du tube dans une/des zone(s) choisie(s) entre les deux électrodes les plus espacées. Pour ce faire, le tube présente des moyens d'injection et des moyens d'évacuation/d'aspiration agencés le long du tube au niveau de ces zones. La position d'un point d'injection ou d'un point d'extraction peut coïncider avec la position d'une électrode intermédiaire. L'ensemble du tube est ainsi segmenté en zones de traitement distinctes. Les traitements effectués dans chacune de ces zones peuvent être différents : le traitement peut différer d'une section à l'autre par la composition du gaz d'apport. Le traitement peut également différer du traitement de la section voisine par les caractéristiques électriques du plasma établi entre deux électrodes voisines. Un tel dispositif permet, par exemple, d'effectuer en continu, dans 3 zones successives, d'amont en aval dans le sens de défilement du fil, un décapage, une activation de surface et le dépôt d'un film. Pour ce faire, le dispositif comporte de préférence un générateur électrique, ou un ensemble de générateurs, capable de délivrer simultanément à une pluralité de paires d'électrodes des courants aptes à générer un plasma, les tensions délivrées à ces électrodes étant choisies parmi
les tensions continues,
les tensions continues pulsées,
les tensions alternatives basse fréquence,
les tensions alternatives haute fréquence,
les tensions alternatives dans la gamme de fréquence des micro-ondes.

On peut également utiliser une tension modulée, combinant deux ou plusieurs des tensions électriques mentionnées ci-dessus, une tension délivrée par un premier générateur étant modulée à l'aide d'un deuxième générateur. Parmi les tensions alternatives basse fréquence, la tension du réseau, c'est-à-dire 50 ou 60 Hertz en général, est particulièrement préférée parce qu'elle permet d'abaisser le coût du générateur électrique.

La valeur de la tension appliquée est proportionnelle à la longueur de la zone de traitement et dépend de la nature du traitement. La forme du signal électrique dépend essentiellement de la nature du traitement à effectuer.

D'autres caractéristiques du procédé et du dispositif selon l'invention ressortiront pour l'homme du métier de la description ci-dessous, montrant plusieurs modes d'exécution du dispositif ainsi que des exemples d'application du procédé, en se référant aux figures du dessin, dans lequel:
- la figure 1 est une vue schématique en coupe longitudinale d'un premier mode d'exécution du dispositif de traitement,
- la figure 2 montre une vue schématique en coupe longitudinale d'un deuxième mode d'exécution du dispositif de traitement,
- la figure 3 montre une vue schématique en coupe longitudinale d'un troisième mode d'exécution du dispositif de traitement,
- la figure 4 montre une vue schématique en coupe longitudinale d'un quatrième mode d'exécution du dispositif de traitement,
- la figure 5 montre une vue schématique en coupe longitudinale d'un cinquième mode d'exécution du dispositif de traitement,
- la figure 6 montre une vue schématique en coupe longitudinale d'un sixième mode d'exécution du dispositif de traitement,
- la figure 7 montre une vue schématique en coupe longitudinale d'un septième mode d'exécution du dispositif de traitement,
- la figure 8 montre une vue schématique en coupe longitudinale d'un huitième mode d'exécution du dispositif de traitement.
- la figure 9 montre une microphotographie d'un fil traité selon l'exemple d'application 1.
- la figure 10 montre une photographie d'un fil traité selon l'exemple d'application 2.
- la figure 11 montre une microphotographie d'un fil traité selon l'exemple d'application 4.
- la figure 12 montre un neuvième mode d'exécution fonctionnant avec un générateur de micro-ondes.
- la figure 13 montre une vue schématique en coupe longitudinale d'un dixième mode d'exécution du dispositif de traitement.
- la figure 13a est une coupe transversale selon le plan A-B de la figure 13.
- la figure 14 montre une vue schématique en coupe longitudinale d'un onzième mode d'exécution du dispositif de traitement.
- la figure 14a est une coupe transversale selon le plan A-B de la figure 14.
- la figure 15 montre une vue schématique en coupe longitudinale d'un douzième mode d'exécution du dispositif de traitement.
- la figure 15a est une coupe transversale selon le plan A-B de la figure 15.

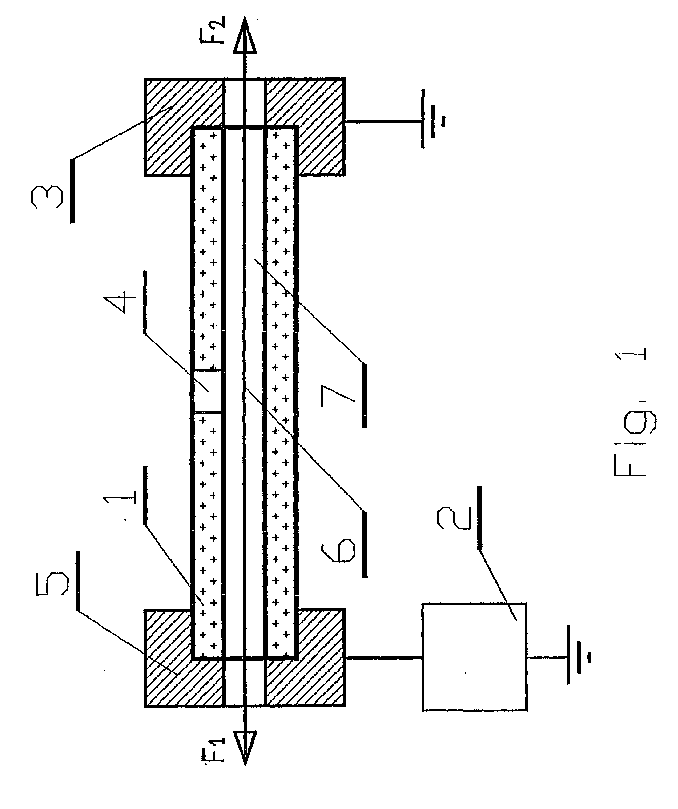

La figure 1 montre en coupe longitudinale un tube cylindrique creux 1 en quartz, ouvert à ses deux extrémités. Sur les deux extrémités du tube 1 sont agencées deux électrodes 3 et 5, présentant la forme de cylindres alésés pour recevoir les extrémités du tube 1 et percés d'une lumière. Le diamètre des lumières est égal au diamètre intérieur du tube 1; elles sont disposés dans le prolongement des parois intérieures du tube 1. Le contact entre électrodes et matériau diélectrique doit être réalisé sans interstices pour éviter des arcs parasites. L'électrode 3 est reliée à la masse. L'électrode 5 est reliée à un générateur électrique 2, lui-même relié par ailleurs à la masse. Le générateur 2 peut être un générateur de tension continue, un générateur de courant alternatif basse fréquence ou un générateur de courant alternatif haute fréquence. Une entrée de gaz porteur est représentée schématiquement en 4 (les tubulures d'amenée de gaz n'étant par représentées). Le gaz porteur peut être de l'air enrichi en argon, pour diminuer la tension nécessaire à la décharge électrique. Les flux du gaz qui s'écoulent depuis l'entrée 4 vers les deux électrodes 3 et 5 ont également pour fonction l'élimination des produits d'érosion des électrodes. Si une tension continue est appliquée, la cathode est beaucoup plus érodée que l'anode; si une tension alternative est appliquée entre les électrodes 3 et 5, les deux subissent une érosion similaire.

Des dispositifs de tension mécanique et d'entraînement, en soi connus et non représentés sur la figure 1, disposés à l'extérieur du tube 1, permettent de maintenir une portion 6 d'un fil tendue et animée d'un mouvement de défilement dans la direction longitudinale du tube, sensiblement en coïncidence avec l'axe du tube, dans le sens de l'une ou de l'autre des flèches F1 ou F2.

L'application d'une tension électrique suffisante, entre les électrodes 3 et 5, crée une décharge électrique au sein du canal intérieur 7 du tube 1. Au besoin, une paire d'électrodes d'allumage (non représentée) peut être disposée le long du tube, à distance plus faible que celle qui sépare les électrodes 3 et 5 pour l'ignition de la décharge électrique, qui se propage ensuite entre les électrodes 3 et 5. Grâce aux propriétés diélectriques du matériau constituant les parois intérieures du tube 1, la décharge électrique génère un plasma confiné au sein du canal 7. Ce plasma est sensiblement homogène dans tout le canal. On constate que la portion 6 du fil, dont la surface est à traiter, est plongée entièrement dans la colonne de plasma. Dans un plan transversal, la surface du corps filiforme subit les mêmes interactions avec le milieu plasmatique, de tous les côtés, contrairement à ce qui se produit pour un corps filiforme (tige, ruban ou fil) se déplaçant en défilant perpendiculairement à un jet de torche à plasma.

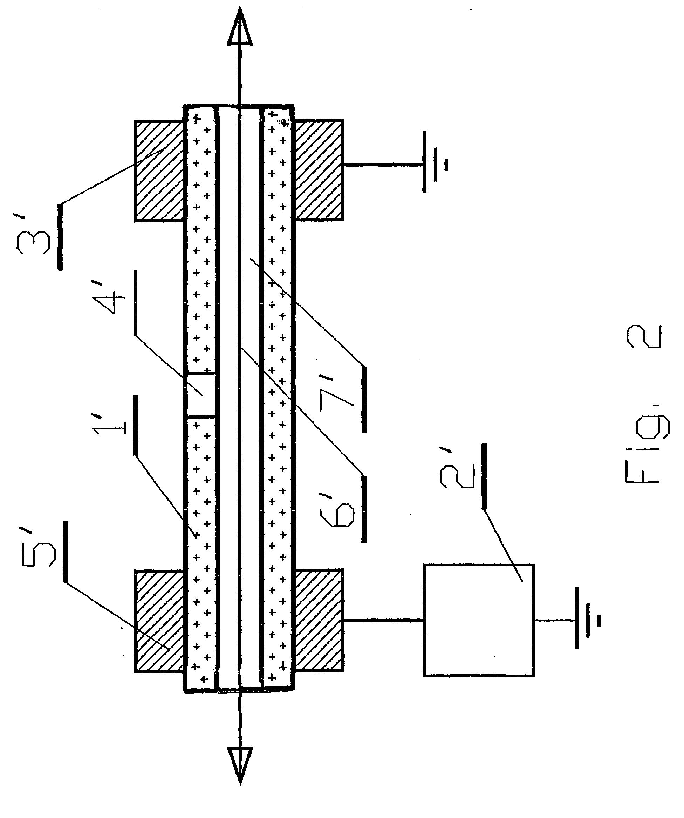

Le mode d'exécution représenté schématiquement sur la figure 2 diffère du mode d'exécution représenté sur la figure 1 en ce que les électrodes 3' et 5' présentent la forme de cylindres creux de dimension adaptée à pouvoir être emmanchés en contact étroit, sur les parois extérieures du tube 1'. Les électrodes 3' et 5' sont agencées en dehors du canal, sur la surface externe du tube pour réduire l'usure des électrodes et éviter une contamination du plasma par les produits d'érosion des électrodes. Dans ce mode d'exécution, le générateur 2' délivre un courant alternatif de haute fréquence (de quelques kilohertz à quelques centaines de Mégahertz), ou dans la gamme de fréquence des micro-ondes. Dans ce dernier cas, l'électrode 5' couple dans le plasma l'énergie reçue d'un guide d'ondes lui-même alimenté par un générateur micro-ondes. Ce dispositif permet de traiter des corps filiformes en matériaux conducteurs ou semi-conducteurs. Comme dans le mode d'exécution décrit en relation avec la figure 1, un gaz porteur est introduit dans le canal 7' via le dispositif d'amenée 4'. Ce gaz porteur peut servir de vecteur à une composante de traitement plasmochimique.

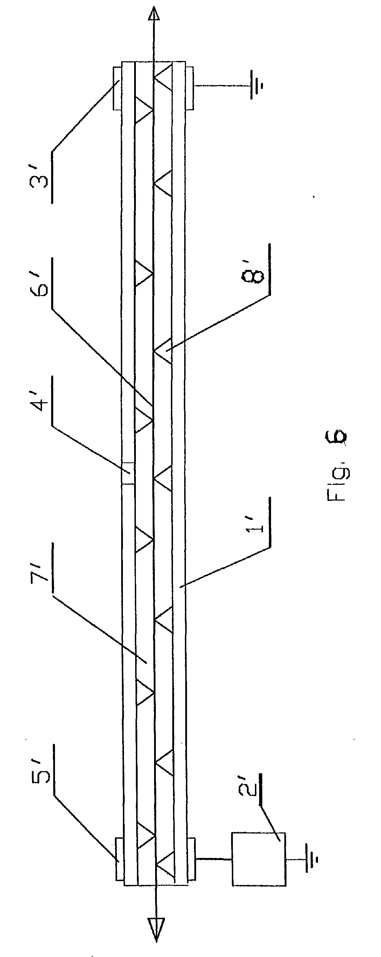

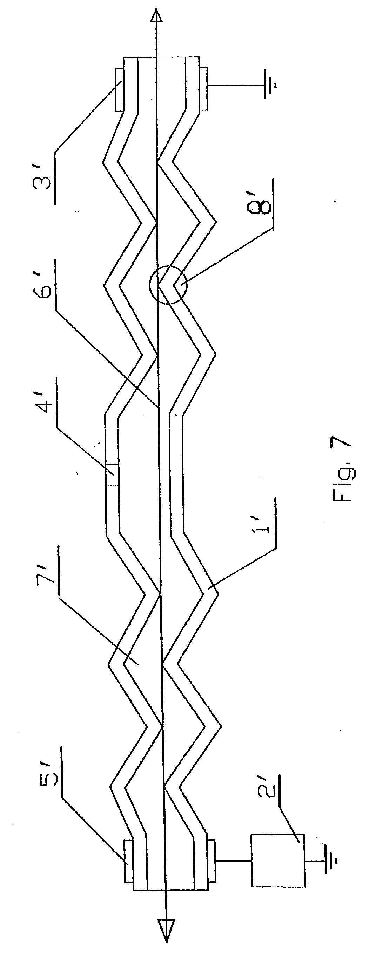

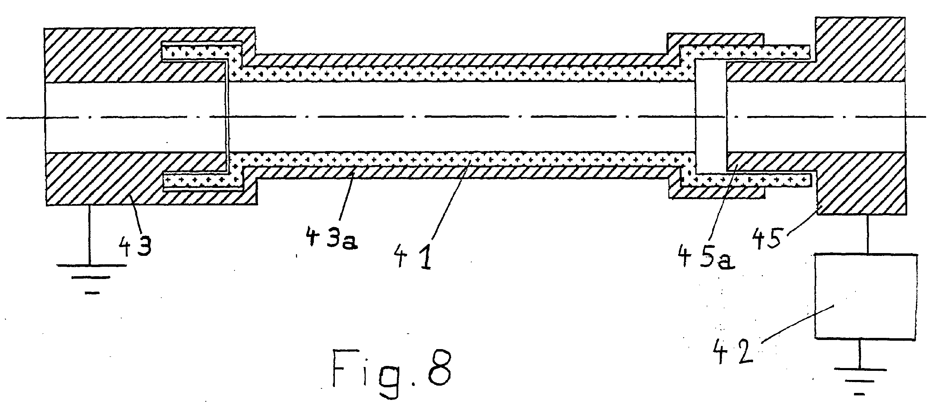

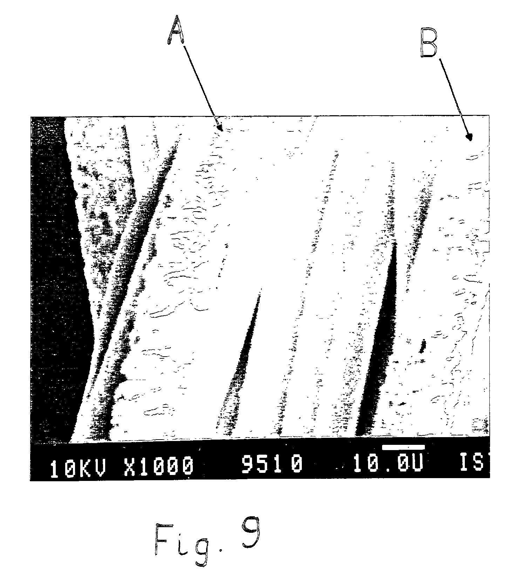

Dans les modes d'exécution qui viennent d'être décrits, la portion du corps filiforme traversant le tube est maintenue en position sensiblement centrale à l'aide de dispositifs de tension et de dispositifs d'entraînement extérieurs au tube, tels que ceux utilisés dans l'industrie textile pour faire défiler un fil à travers une succession de postes de traitement. Selon sa tension et la longueur du tube à décharge, le fil a tendance à prendre une flèche et/ou à vibrer, de sorte qu'il viendrait à frotter contre la paroi intérieure du tube et à ne pas se trouver au sein du plasma. Les figures 6 et 7 montrent deux modes d'exécution du dispositif de traitement comportant, à l'intérieur même du tube à décharge, des moyens pour positionner la portion du corps filiforme passant à l'intérieur du tube, en moyenne sensiblement dans la zone centrale du tube.

La figure 6 montre, avec les mêmes numéros de référence que la figure 2, un tube de structure sensiblement identique à celle du deuxième mode d'exécution. A l'intérieur du tube, se trouvent des picots 8' régulièrement espacés, supportant le fil et dont la direction transversale varie de picot en picot. Ce système de picots compense une flèche due à une tension du fil insuffisante et empêche également l'établissement d'un système de vibrations mécaniques du fil en cours d'avancement.

Sur la figure 7, montrant un mode d'exécution par ailleurs proche de celui de la figure 2, avec les mêmes numéros de référence, le tube, au lieu d'être droit, présente une succession de segments légèrement inclinés par rapport à la direction longitudinale générale du tube, l'inclinaison s'inversant de segment en segment. Dans son mouvement, le fil prend des appuis successifs 8' sur les parois du tube au niveau des lignes de changement de direction, mais, globalement et en dehors de ces points d'appuis discrets, le fil est maintenu dans la colonne de plasma, qui, elle, suit sensiblement les méandres du tube et occupe tout le volume intérieur.

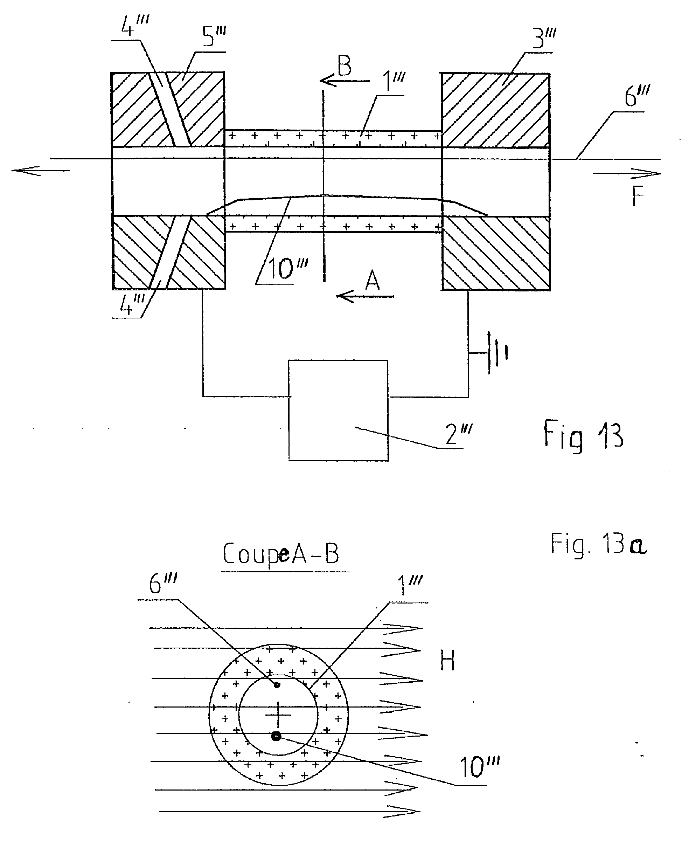

Le mode d'exécution représenté schématiquement sur la figure 13 diffère du mode d'exécution représenté sur la figure 1 en ce que des entrées de gaz porteur 4''' sont constituées de tubulures d'amenées creusées à travers le corps de l'électrode potentielle 5'''. Une pluralité de tubulures d'amenée 4''' est agencée symétriquement par rapport à l'axe du tube 1'''. Au moyen d'un dispositif non représenté sur la figure 13, tel que par exemple des électroaimants disposés autour du tube 1''', on crée un champ magnétique H perpendiculaire à l'axe du tube 1'''. Du fait du champ magnétique H, l'axe de la colonne de plasma ne coïncide plus avec l'axe du tube; la zone de plus forte densité de courant se déplace en direction de la paroi intérieure du tube 1''' comme le symbolise la ligne 10'''. Le corps filiforme 6''' est également décalé en direction de la paroi du tube, mais en sens opposé du décalage de la colonne de plasma. Les lignes de champ magnétique, ainsi que les positions du corps filiforme 6''' et de la colonne de plasma 10''' sont représentés schématiquement sur la figure 13a. Ce mode de réalisation permet de traiter un corps filiforme, uniformément de tous côtés et dans une zone de plasma plus froide que la zone qui se trouve à proximité immédiate du centre de la colonne de plasma.

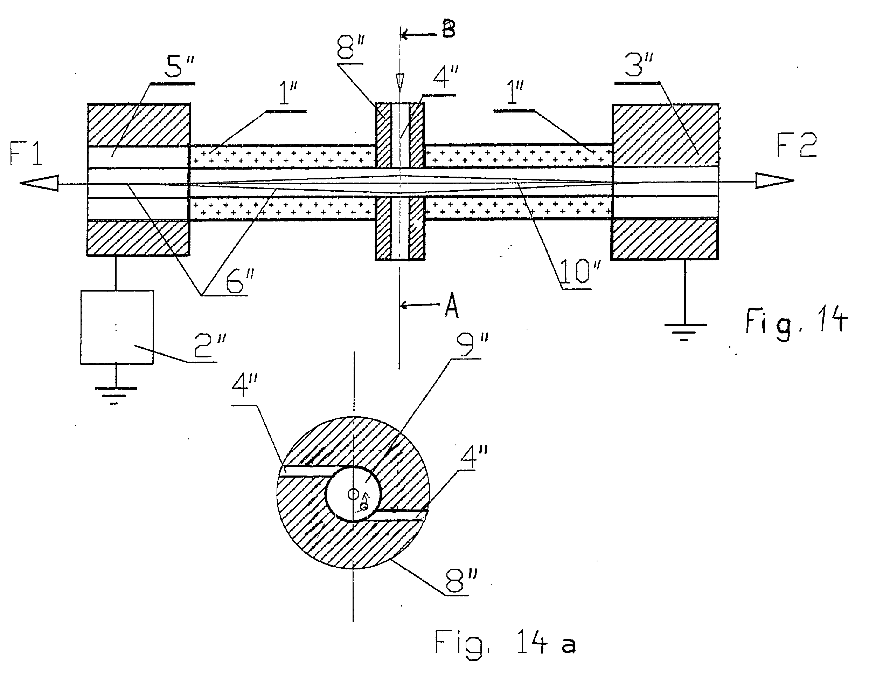

Le mode d'exécution représenté à la figure 14 diffère du mode d'exécution représenté sur la figure 1 en ce que le tube 1'' est constitué de deux tronçons de tube. Entre les deux tronçons est placé une pièce 8'' en matériau diélectrique. La pièce 8'' présente la forme d'un anneau percé d'une lumière 9'', comme le montre la figure 14a, dont le diamètre est égal au diamètre intérieur du tube 1''. Dans la lumière 9'' débouchent deux tubulures d'injection 4'' agencées de manière à injecter le gaz porteur tangentiellement, comme le montre la figure 14a. Le mouvement tourbillonnant du flux gazeux généré par l'agencement des tubulures 4'' permet de maintenir l'axe de la colonne de plasma en coïncidence avec l'axe du tube. D'autre part, le mouvement du flux gazeux met en mouvement le corps filiforme 6'' qui entre en rotation autour de l'axe du tube. Selon la vitesse du flux gazeux injecté, c'est le plasma qui tourne autour du fil ou au contraire le fil qui tourne autour de la colonne de plasma, mais, dans les deux cas, il se produit un mouvement de rotation relatif du fil à l'intérieur de la colonne de plasma. Ce phénomène contribue à homogénéiser le traitement de tous les côtés du fil. On constatera également que dans la zone centrale du tube, le fil est écarté de l'axe de la colonne de plasma.

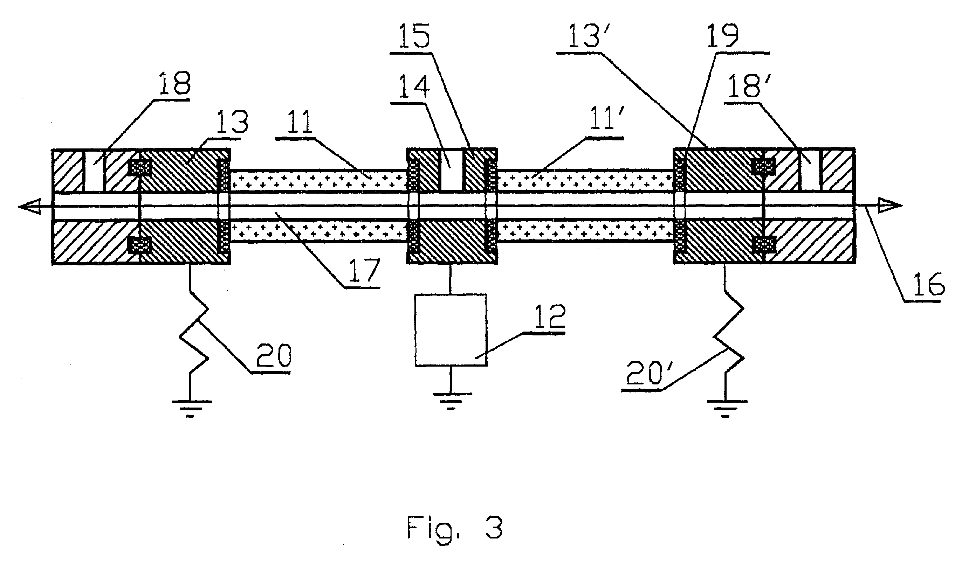

La figure 3 est une coupe longitudinale d'un troisième mode d'exécution du dispositif de traitement. Le tube est constitué de deux tronçons de tube en quartz 11 et 11'. Les deux tronçons 11 et 11' sont séparés par une électrode cylindrique 15 avec une lumière axiale dont le diamètre est égal au diamètre intérieur des tubes 11, 11', en formant un canal 17. L'électrode 15 est reliée à un générateur électrique 12 et sert d'électrode potentielle. L'électrode 15 est également munie d'une tubulure 14 permettant l'amenée ou l'évacuation de gaz porteur. Aux deux extrémités du tube 11, 11' sont agencées deux électrodes 13, 13' reliées à la terre par l'intermédiaire de deux résistances 20, 20'. Dans le prolongement des deux électrodes 13, 13' se trouvent deux systèmes de dégazage 18, 18' permettant soit de souffler, soit d'aspirer un gaz. Ce système de dégazage permet d'avoir à l'intérieur du tube 11, 11' une atmosphère parfaitement contrôlée, introduite en 14, qui ne contient que les composantes nécessaires et suffisantes pour le procédé de traitement. Il permet en effet d'éliminer par soufflage et/ou aspiration en 18 ou 18'les gaz entraînés par l'avancement du fil 16, notamment lorsque celui-ci est constitué de fibres entrelacés enfermant entre elles un certain volume d'air ambiant. Des joints 19 assurent l'étanchéité entre les différentes pièces du dispositif.

Dans ce mode d'exécution, les électrodes 15 et 13, 13' sont en matériau conducteur, par exemple en cuivre, alors que les tronçons 11, 11' du tube sont constituées d'un matériau diélectrique. Le générateur de courant 12 peut être une source de courant alternatif ou à impulsions. La tension entre l'électrode potentielle 15 et l'électrode reliée à la masse 13 est égale à la tension entre l'électrode 15 et l'électrode 13'. Dans ces conditions, avec un gaz porteur introduit en 14 et extrait en 18 et 18', les conditions régnant à l'intérieur des tronçons 11 et 11' sont identiques, si les longueurs des tronçons 11 et 11' sont égales.

Une comparaison avec la figure 1 montre que si les générateurs 2 et 12 délivrent la même tension, et si les fils 6 et 16 défilent à la même vitesse, le dispositif montré à la figure 3 permet, dans les mêmes conditions de traitement, de doubler le temps de contact entre le fil et le plasma; inversement, à durée de contact égale entre une portion du fil 16 et du plasma, ce dispositif permet de doubler la vitesse de défilement du fil.

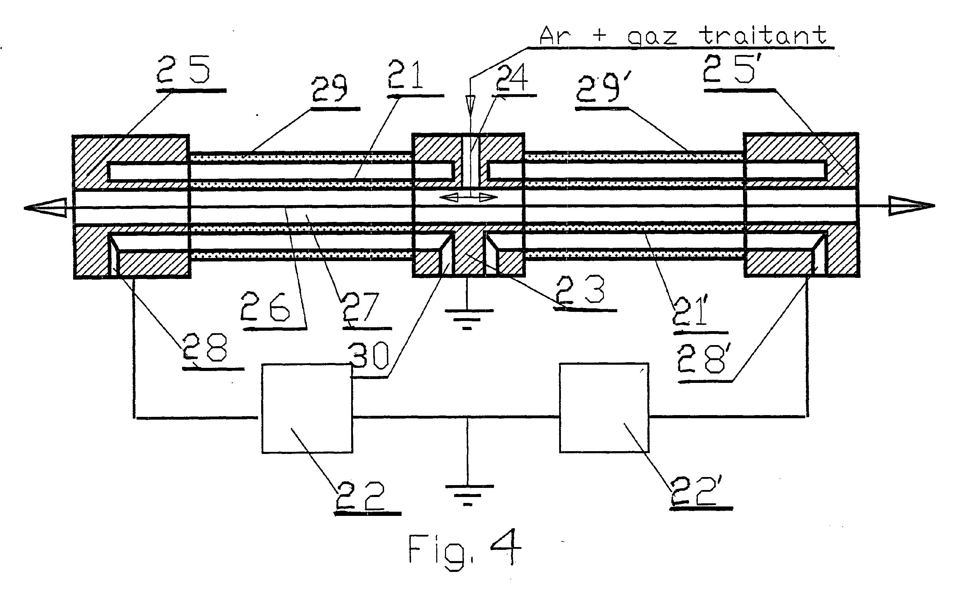

La figure 4 montre un quatrième mode d'exécution du dispositif de traitement doté d'un système de refroidissement du tube et des électrodes. Le tube en deux tronçons 21 et 21' est un tube en quartz installé à l'intérieur d'un autre tube en deux tronçons 29, 29'. L'ensemble des tronçons de tube est refroidi à l'aide d'un flux d'air comprimé passant entre les tubes intérieurs 21, 21' et extérieurs 29, 29' et à l'intérieur de tubulures 28, 28' et 30 creusées dans les électrodes métalliques 23 et 25, 25'. Le système de refroidissement assure le refroidissement des pièces du dispositif, tube diélectrique et électrodes. Il n'a pratiquement pas d'influence sur les conditions de température régnant au sein du plasma confiné dans le canal 27. Les deux électrodes les plus espacées 25 et 25', situées aux deux extrémités du tube 21, 21' sont reliées respectivement à deux générateurs électriques 22 et 22' et servent d'électrodes potentielles, alors que l'électrode centrale 23 est reliée à la terre. Les tensions électriques délivrées par les deux sources de courant 22 et 22' peuvent être différentes l'une de l'autre, ce qui permet de définir deux tronçons de traitement, à l'intérieur respectivement des tronçons 21 et 21' du tube, confinant deux plasmas dans des conditions physiques différentes.

Un système d'amenée de gaz d'apport 24 au niveau de l'électrode centrale 23, gaz qui se sépare en deux flux de directions opposées, en direction des deux extrémités du tube, contribue à maintenir des conditions de traitement distinctes dans les deux tronçons du tube.

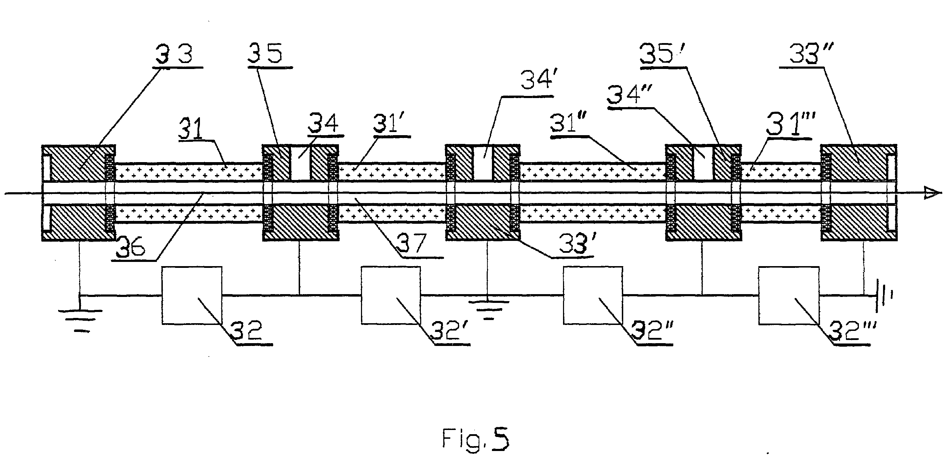

La figure 5 montre un mode d'exécution du dispositif de traitement segmenté en plusieurs tronçons, permettant de faire subir au fil 36, en train de défiler dans une ligne de production, un traitement en plusieurs étapes successives différant par les compositions chimiques des milieux gazeux des tronçons, et cela dans le cadre d'un procédé en continu.

Le tube à décharge comprend quatre tronçons de tubes en céramique frittée 31, 31', 31'', 31''', alignés pour former un canal 37. Aux deux extrémités sont situées deux électrodes 33 et 33''; les tronçons sont séparées par trois électrodes intermédiaires 35, 33' et 35'. Les électrodes 33, 33' et 33'' sont mises à la terre; les électrodes 35 et 35' servent d'électrodes potentielles. Quatre tensions électriques, identiques ou différentes, sont délivrées respectivement par quatre sources de courant, 32 pour le couple d'électrodes 33 et 35, 32' pour le couple d'électrodes 35 et 33', 32'' pour le couple d'électrodes 33' et 35' et 32''' pour le couple d'électrodes 35' et 33''. Les électrodes 35 et 35' sont munies de dispositifs d'alimentation de gaz d'apport 34 et 34''; l'électrode centrale 33' est munie d'un système d'évacuation de gaz 34'. En fonctionnement, deux flux gazeux de même composition s'écoulent de l'électrode 35 vers les électrodes 33 et 33' et deux autres flux gazeux de même composition l'un que l'autre s'écoulent depuis l'électrode 35' vers les électrodes 33' et 33'' respectivement. Les gaz d'apport introduits en 34 et en 34'' peuvent être de compositions chimiques différentes, de sorte que le milieu des tronçons 31'' et 31''' d'une part diffère de celui des tronçons 31 et 31' d'autre part. Le système d'évacuation 34' aspire les 2 flux gazeux en provenance des électrodes 35 et 35', évitant les mélanges. Si le fil 36 défile de la gauche vers la droite, dans le sens de la flèche sur la figure 5, la moitié de gauche du dispositif, depuis l'électrode 33 jusqu'à l'électrode 33', peut être utilisée pour un traitement préliminaire, par exemple l'épilation ou le décapage d'un fil ou encore un préchauffage, pour préparer le fil pour le traitement suivant. La moitié de droite du dispositif, depuis l'électrode 33' jusqu'à l'électrode 33'' peut servir à donner au fil l'état de surface final désiré, par exemple par dépôt d'un revêtement.

Les tensions délivrées par les quatre sources de courant 32, 32', 32'', 32''' peuvent être toutes différentes : les conditions physico-chimiques régnant dans les quatre tronçons 31, 31', 31'' et 31''' peuvent donc être toutes différentes les unes des autres selon les besoins. Le fil 36 qui défile à travers l'ensemble du tube peut donc subir jusqu'à quatre étapes de traitement successives différentes sur son parcours.

Le dispositif de traitement selon l'invention peut faire l'objet de nombreuses modifications sans sortir du cadre de l'invention.

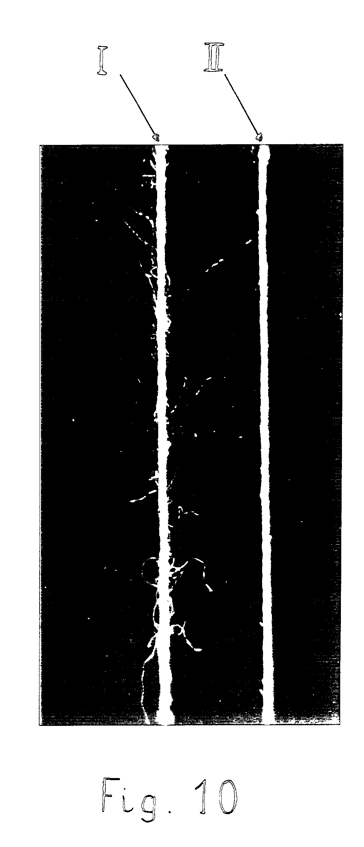

La figure 8 illustre, à titre d'exemple, un mode d'exécution proche dans son régime de fonctionnement du premier mode d'exécution, mais différent dans son mode d'ignition, dans lequel l'électrode potentielle 45 reliée au générateur 42 porte un prolongement 45a à l'intérieur du tube et l'électrode de masse 43 porte un prolongement 43a à l'extérieur du tube 41. Le prolongement 43a vient jusqu'au niveau du prolongement 45a, dont il est séparé par le matériau diélectrique. Lors de la mise sous tension, l'ignition du plasma est facilitée et se fait à ce niveau, par un effet de type corona, puis se propage le long du tube. Ensuite, en régime établi, la décharge se stabilise entre les portions des électrodes 43 et 45 situées aux extrémités du tube. Le prolongement 43a peut former une gaine, mettant la majeure partie de l'extérieur du dispositif à la masse.

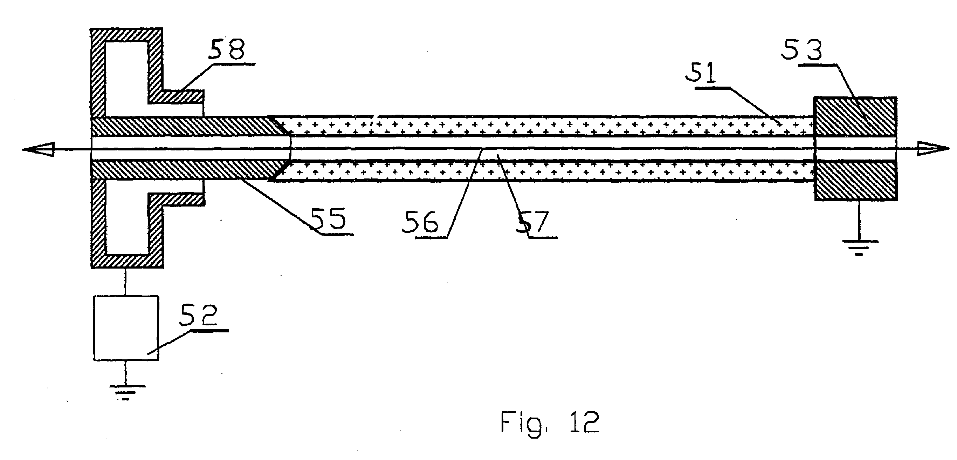

La figure 12 illustre un mode d'exécution mettant en oeuvre une tension dans la gamme de fréquence des micro-ondes. L'électrode potentielle 55 est un cylindre biseauté placé dans le prolongement du tube 51 et présentant le même diamètre. Un guide d'onde 58 entoure l'électrode 55 pour coupler l'énergie reçue d'un générateur à micro-ondes 52. Un corps filiforme 56 défile dans le canal intérieur 57 du tube 51 et sort en traversant l'électrode de masse 53.

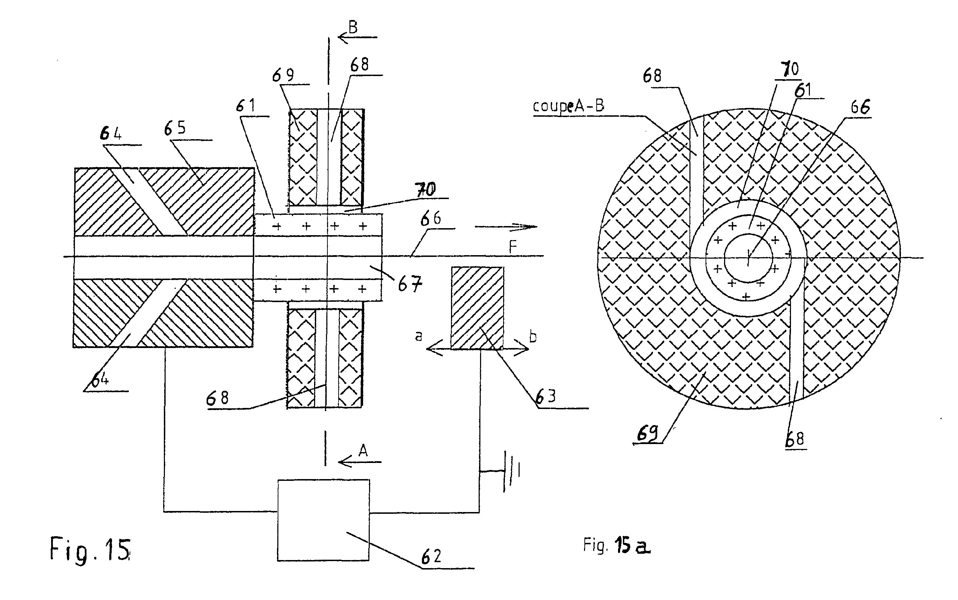

La figure 15 représente un mode d'exécution facilitant l'allumage du plasma lorsqu'on utilise des gaz porteurs ayant une haute tension de claquage électrique, tel que l'air ou l'azote. L'électrode potentielle 65, alimentée par le générateur 62 est traversée par des tubulures d'injection 64 injectant un flux gazeux dans le canal intérieur 67 du tube 61. L'extrémité opposée du tube 61 est libre. L'électrode de masse 63, sous forme d'une tige ou d'une lamelle, n'est pas fixée au tube 61; elle est mobile dans le sens des flèches a b. Pour l'allumage, l'électrode de masse 63 est rapprochée au maximum du tube 61. Elle peut ensuite en être écartée dans la direction b selon les paramètres de traitement souhaités.

Le gaz porteur introduit dans le dispositif via les tubulures d'injection 64 qui traversent l'électrode 65. Le flux gazeux traverse le tube 61 et s'échappe librement par l'ouverture opposée du tube 61. Du fait du débit important du gaz porteur, la composition des gaz dans la zone où passe le corps filiforme 66, entre l'extrémité libre du tube 61 et l'électrode 63, est identique à celle à l'intérieur du tube 61. La composition du plasma, dont la colonne se prolonge depuis le canal 67 intérieur au tube 61 jusqu'à l'électrode 63 est de ce fait homogène.

Optionnellement, un dispositif de refroidissement, représenté sur la figure 15 et sur la figure 15a peut être placé autour du tube 61. Il est constitué d'une pièce annulaire ou cylindrique 69 constituée d'un matériau isolant. La pièce 69 présente une ouverture 70 légèrement plus grande que les dimensions extérieures du tube 61 pour laisser un espace libre autour du tube de l'ordre de 0,1 à 1 mm. La pièce 69 est percée de canaux 68 agencés de manière à injecter un gaz de refroidissement tangentiellement par rapport à la surface extérieure du tube 61. Le gaz de refroidissement tourbillonne dans l'interstice entre la pièce 69 et le tube 61 et s'échappe par les deux côtés. Ce dispositif de refroidissement simultanément évite la surchauffe du tube et par ailleurs évite un claquage électrique à l'extérieur du tube 61.

Le procédé et les dispositifs selon l'invention permettent de traiter des corps filiformes variés avec un volume de plasma très faible. Ce petit volume entraîne une consommation d'énergie électrique et de gaz de traitement également très faible.

Les exemples non-limitatifs suivants illustrent des applications du procédé selon l'invention pour divers traitements de surfaces de fils en matériaux synthétiques et naturels.

### Exemple 1: décapage d'un fil

Le dispositif utilisé est du type de celui représenté sur la figure 4. Le tube intérieur est un tube en quartz installé à l'intérieur d'un autre tube en quartz. La longueur totale du tube, y compris les électrodes placées aux deux extrémités est de 180 mm et le diamètre intérieur du tube intérieur est de 2 mm. Le refroidissement du tube et des électrodes est assuré par un flux d'air comprimé passant entre les deux tubes avec un débit d'environ 30 litres/min.

Le plasma est généré au moyen d'une tension électrique alternative de 1'000 volts, appliquée entre l'électrode de masse et chacune des électrodes potentielles. L'intensité du courant électrique est de 100 mA.

Le dispositif est utilisé pour traiter un fil aramide de diamètre 0,3 mm, défilant dans le tube avec une vitesse de 6 m par seconde. Le fil est maintenu tendu, sensiblement en coïncidence avec l'axe du tube à l'aide d'un mécanisme extérieur.

Le plasma est entretenu à l'aide d'un gaz porteur introduit à travers l'électrode centrale de masse. Le gaz porteur est de l'argon, contenant de l'oxygène et 2-4% d'ozone, rapporté à la quantité d'oxygène, en qualité de gaz traitant. Le débit total de gaz porteur est de 3 litres par minute et le débit d'oxygène + ozone est de 0,03 litres/minute. Le flux gazeux s'échappe librement par les ouvertures des deux électrodes potentielles situées aux extrémités du tube, à pression ambiante. Aucune enceinte à vide n'est disposée autour du dispositif.

L'observation microscopique montre un décapage uniforme sur toute la surface du fil, tel que l'illustre les fils A et B de la microphotographie de la figure 9.

### Exemple 2: épilation d'un fil

Le dispositif utilisé est du type de celui illustré par la figure 4.

La tension appliquée entre l'électrode 23 et les électrodes 25 et 25' est de 1 kV, DC. L'intensité du courant électrique est de 100 mA. Un gaz porteur est introduit par le système d'admission 24 de l'électrode 23. Il est constitué d'argon, avec un débit de 5 litres/minute contenant de l'oxygène + ozone avec un débit de 0,05 litres/minute.

Les flux gazeux s'échappent par les lumières centrales des électrodes 25 et 25'. Les gaz sont recueillis par une hotte mais aucune enceinte à vide n'est installée autour du dispositif.

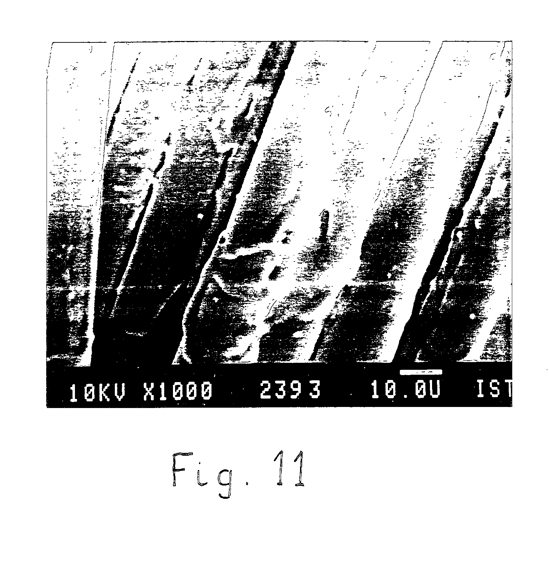

Le fil traité est un polyester de 0,3 mm de diamètre. Comme le montre la photographie de la figure 10, en amont du dispositif de traitement, la surface du fil I présente des micro-filaments formant une pilosité à la surface du fil. A la sortie du dispositif, la surface du fil II est libre de micro-filaments et présente, au palpage, un toucher "sec et non rugueux".

### Exemple 3 :Changement de la mouillabilité d'un fil polyester

Cet exemple montre qu'avec un même gaz d'apport, selon la tension électrique utilisée, deux traitements différents peuvent être obtenus. Le dispositif utilisé est du type de celui illustré par la figure 4.

| Régime 1 | |
|---|---|
| Type et valeur du courant | DC, 100 mA |
| Tension appliquée au plasma | 2,0 kV |
| Débit d'argon | 7,61/min |
| Débit d'oxygène/ozone | 0,026 l/min |
| Débit d'hexamethyldisilazane | 3,6 gr/heur |
| Longueur du canal | 180 mm |
| Type de fil traité | polyester |

On constate une augmentation de 50% de la mouillabilité de la fibre traitée.

| Régime 2 | |
|---|---|
| Type et valeur du courant | AC 50 hertz, 100 mA |
| Tension appliquée au plasma | 2,0 kV |
| Débit d'argon | 7,6 l/min |
| Débit d'oxygène/ozone | 0,026 l/min |
| Débit d'hexamethyldisilazane | 3,6 gr/heur |
| Longueur du canal | 180 mm |
| Type de fil traité | polyester |

On constate une diminution de la mouillabilité de 25% de la fibre.

### Exemple 4 : Dépôt de SiOₓ sur un fil polyester

Le dispositif utilisé est du type de celui illustré par la figure 4.

Les conditions du traitement sont les suivantes :

| | |
|---|---|
| Type et valeur du courant | AC, 100 mA |
| Tension appliquée au plasma | 2,0 kV |
| Débit d'argon | 7,6 l/min |
| Débit d'oxygène/ozone | 0,026 l/min |
| Débit d'hexamethyldisilazane | 3,6 gr/heure |
| Longueur du canal | 180 mm |

La microphotographie de la figure 11 montre la croissance d'un film SiOₓ sur un fil polyester après un traitement de 60 ms dans les conditions indiquées ci-dessus.

Dans les exemples ci-dessus, l'observation des fils après traitement complet montre des résultats homogènes sur toute la surface des fils traités.

### Exemple 5: Épilation d'un fil de coton

Le dispositif utilisé est du type de celui illustré par la figure 15.

La longueur du tube 61, en quartz, est de 40 mm. L'électrode de masse 63 est initialement placée contre l'extrémité libre du tube 61 pour initier la décharge. Elle est ensuite écartée de cette extrémité d'environ 20 mm. Les produits d'érosion de l'électrode 63 ne peuvent donc pas venir encrasser les parois intérieures du tube 61. La tension appliquée en régime établi entre les électrodes 65 et 63 est de 2 kV, DC. Le courant électrique est de 170 mA. Le gaz porteur est constitué d'air, avec un débit de 15 litres par minute, sans autre additif.

Le fil traité est un fil de coton de 0,3mm de diamètre dont la surface extérieure présente des micro-filaments formant une pilosité. A la sortie du dispositif, le fil est débarrassé de cette pilosité le résultat est similaire à celui montré par le photographie de la figure 10.

## Revendications

1. Procédé de traitement de surface d'un corps filiforme avec un plasma généré par une décharge électrique,
caractérisé en ce que
au moins deux électrodes (3, 3', 3'', 3''', 5, 5', 5'', 5"', 13, 13', 15, 23, 25, 25', 33, 33', 33", 35, 35', 43, 45, 53, 55, 63, 65) sont agencées le long ou au voisinage de l'extrémité d'un tube (1, 1', 1'', 1''', 11, 11', 21, 21', 31, 31', 31'', 31''', 45, 51, 61) en matériau diélectrique, en étant espacées l'une de l'autre en direction longitudinale dudit tube,
une tension électrique apte à produire ladite décharge électrique dans ledit tube est appliquée entre deux desdites électrodes, de façon à générer une colonne de plasma sensiblement confinée entre les parois intérieures dudit tube,
au moins une portion (6, 6', 6'' , 6''', 16, 26, 36, 45, 46, 56, 66) dudit corps filiforme est amenée à l'intérieur dudit tube, entre lesdites deux électrodes, la direction longitudinale de ladite portion du corps filiforme coïncidant sensiblement avec ladite direction longitudinale dudit tube,
et que ladite portion du corps filiforme et ledit tube sont soumis à un mouvement relatif (F, F1, F2) l'un par rapport à l'autre, dans ladite direction longitudinale dudit tube.

2. Procédé selon la revendication 1, caractérisé en ce que ledit corps filiforme est choisi parmi les monofils, les fils tressés, les fibres entrelacées, les bandes et les rubans, et défile en un mouvement continu dans ledit tube en traversant deux ouvertures distales dudit tube.

3. Procédé selon la revendication 1 ou la revendication 2, caractérisé en ce que l'intérieur du tube (1, 1', 1'', 1''', 11, 11', 21, 21', 31, 31', 31'', 31''', 45, 51, 61) est en communication fluide avec l'atmosphère extérieure.

4. Procédé selon l'une des revendications 1-3,
caractérisé en ce que ladite tension électrique est choisie dans le groupe constitué par les tensions continues, les tensions continues pulsées, les tensions alternatives de basse fréquence, en particulier les tensions de fréquence 50 Hertz ou 60 Hertz, les tensions alternatives de haute fréquence, les tensions alternatives dans la gamme de fréquence des micro-ondes et les tensions modulées combinant les précédentes.

5. Procédé selon l'une des revendications précédentes,
caractérisé en ce que ledit plasma est entretenu par au moins un flux de gaz porteur se déplaçant dans ledit tube en direction longitudinale, en particulier en ce que la zone d'introduction dudit gaz porteur dans ledit tube est située entre les deux électrodes les plus espacées (3, 3', 3'', 5, 5', 5'', 13, 13', 25, 25', 33, 33'') et que ledit gaz porteur s'écoule en direction des dites deux électrodes.

6. Procédé selon la revendication 5, caractérisé en ce que l'écoulement du dit flux de gaz porteur présente une composante transversale.

7. Procédé selon la revendication 5 ou la revendication 6, caractérisé en ce que le flux de gaz porteur contient une composante de traitement plasmochimique à l'état de gaz ou de vapeur.

8. Procédé selon la revendication 7, caractérisé en ce qu'une pluralité de flux de gaz porteurs, en particulier de gaz présentant des compositions différentes, sont introduits dans des zones distinctes (34, 34'') dudit tube.

9. Procédé selon l'une des revendications 5 à 8,
caractérisé en qu'au moins un flux gazeux est extrait dudit tube en une zone (34') située entre les deux électrodes (33, 33'') les plus espacées.

10. Procédé selon l'une des revendications précédentes,
caractérisé en ce qu'une électrode intermédiaire (15) est agencée entre les deux électrodes (13, 13') les plus espacées, la dite tension électrique étant appliquée entre ladite électrode intermédiaire et chacune des deux autres électrodes.

11. Procédé selon l'une des revendications 1 à 9,
caractérisé en ce qu'une électrode intermédiaire (23) est agencée entre les deux électrodes (25, 25') les plus espacées, ladite électrode intermédiaire servant d'électrode de masse et les deux électrodes les plus espacées servant d'électrodes potentielles, et en ce que des tensions électriques différentes sont appliquées entre les électrodes potentielles respectives et l'électrode intermédiaire de masse.

12. Procédé selon l'une des revendications 1 à 11,
caractérisé en ce que une pluralité d'électrodes intermédiaires (33', 35, 35') sont agencées entre les deux électrodes (33, 33'') les plus espacées, qu'une tension électrique apte à produire une décharge électrique est appliquée entre chaque électrode et les électrodes qui lui sont voisines et, qu'en alternance le long du tube, les électrodes sont utilisées respectivement comme électrodes potentielles et comme électrodes de masse.

13. Procédé selon l'une des revendications précédentes,
caractérisé en ce qu'au moins une portion du dit tube 1''' est soumise à un champ magnétique (H) dont la direction est différente de, et en particulier perpendiculaire à la direction longitudinale de la dite portion du dit tube (1''').

14. Dispositif de traitement de surface d'un ou plusieurs corps filiforme(s) avec un plasma généré par une décharge électrique, caractérisé en ce qu'il comprend un tube (1, 1', 1'', 1''', 11, 11', 21, 21', 31, 31', 31'', 31''', 41, 51, 61) en matériau diélectrique présentant deux extrémités ouvertes, dont la section transversale intérieure est choisie de façon à pouvoir recevoir une portion (6, 6', 6'', 6''', 16, 26, 36, 46, 56, 66) dudit corps filiforme, ou desdits corps filiformes agencés parallèlement entre eux, en laissant un espace entre la surface du (des) corps filiforme(s) et la paroi intérieure dudit tube suffisant pour générer un plasma enveloppant le ou les dit(s) corps filiforme(s), au moins deux électrodes (3, 3', 3'', 3''', 5, 5', 5'', 5''', 13, 13', 15, 23, 25, 25', 33, 33', 33", 35, 35', 43, 45, 53, 55, 63, 65) agencées le long ou au voisinage de l'extrémité dudit tube, en étant espacées entre elles en direction longitudinale du tube.

15. Dispositif selon la revendication 14, caractérisé en ce que la section transversale dudit tube est circulaire ou oblongue, que l'aire de la section transversale est comprise entre 0,03 mm2 et 3 cm2, en particulier entre 3 mm2 et 20 mm2, et que la longueur du tube est comprise entre 5 mm et 1 m, en particulier entre 5 cm et 20 cm de long.

16. Dispositif selon l'une des revendications 14 ou 15,
caractérisé en ce que ledit tube est formé d'au moins deux parties susceptibles d'être séparées pour présenter, dans la direction longitudinale des corps filiformes, une gouttière ouverte et un couvercle, et susceptibles d'être assemblés entre elles de manière étanche à leurs surfaces de jonction.

17. Dispositif selon l'une des revendications 14 à 16,
caractérisé en ce que le matériau diélectrique dudit tube est choisi parmi le quartz et les céramiques, en particulier les céramiques à base d'alumine.

18. Dispositif selon d'une des revendications 14 à 17,
caractérisé par la présence d'au moins une électrode intermédiaire (15, 23, 35, 33', 35') entre les deux électrodes les plus espacées (13, 13', 25, 25', 33, 33').

19. Dispositif selon l'une des revendications 14 à 18,
caractérisé en ce qu'une ou plusieurs électrodes (3, 5, 13, 13', 15, 23, 25, 25', 33, 33', 33'', 35, 35') présentent une lumière, la ou lesdites lumière(s) étant disposée(s) dans le prolongement des parois intérieures dudit tube (1, 11, 11', 21, 21', 31, 31', 31'', 31''').

20. Dispositif selon l'une des revendications 14 à 19,
caractérisé en ce qu'une ou plusieurs desdites électrodes (3', 5') sont percées d'un trou présentant la forme extérieure du dit tube 1' et emmanchées sur les parois extérieures du matériau diélectrique dudit tube (1').

21. Dispositif selon l'une des revendications 14 à 20,
caractérisé par la présence de moyens d'injection (4, 4', 14, 24, 34, 34'') ou d'évacuation (34') d'un flux gazeux dans une zone du tube située entre les deux électrodes (3, 3', 5, 5', 13, 13', 25, 25', 33, 33'') les plus espacées.

22. Dispositif selon l'une des revendications 14 à 20,
caractérisé en ce que la position longitudinale d'un dit moyen d'injection (4, 4', 14, 24, 34, 34'') et/ou d'un moyen d'évacuation (34') d'un dit flux gazeux coïncide avec la position d'une électrode (15, 23, 33', 35, 35').

23. Dispositif selon l'une des revendications 21 ou 22,
caractérisé en ce que un dit moyen d'injection 8'' comprend au moins une tubulure d'injection 4'' agencée de façon à injecter un gaz porteur tangentiellement au dit tube 1'' en matériau diélectrique.

24. Dispositif selon l'une quelconque des revendications 12 à 23 comprenant un premier générateur électrique capable de délivrer des courants aptes à générer un plasma et, en particulier, comprenant un générateur supplémentaire capable d'appliquer une tension se superposant à une tension délivrée par le premier générateur, les tensions délivrées par le ou les dits générateur(s) étant choisies parmi les tensions continues, les tensions continues pulsées, les tensions alternatives basse fréquence, les tensions alternative haute fréquence et les tensions dans la gamme de fréquence des micro-ondes.

25. Dispositif selon l'une des revendications 14 à 24,
caractérisé par la présence de moyens (8, 8') pour positionner ladite portion (6) du ou des corps filiforme(s) à l'intérieur dudit tube sensiblement en coïncidence avec la direction longitudinale du tube, en maintenant ledit espace à la surface de ladite portion du corps filiforme et la paroi intérieure dudit tube.

26. Dispositif selon d'une des revendications 14 à 25,
caractérisé en ce que deux des dites électrodes présentent des prolongements (43a, 45a) respectivement à l'intérieur et à l'extérieur du dit tube, venant sensiblement en regard l'un de l'autre dans un plan transversal et séparés l'un de l'autre par le matériau diélectrique du dit tube.

27. Dispositif selon la revendication 14, caractérisé en ce que le dit générateur est un générateur à micro-ondes dont l'électrode potentielle (5) couple l'énergie dans le plasma par l'intermédiaire d'un guide d'onde (8).

28. Application d'un procédé selon l'une des revendications 1 à 13 à la modification des propriétés de surface d'un fil, en particulier à l'épilation, à la modification de la mouillabilité, ou de l'adhésivité, au nettoyage, au décapage, au revêtement de surface ou au préchauffage.
